# EUROPEAN PATENT APPLICATION

(11) **EP 3 869 536 A1**
(43) Date of publication of application: **25.08.2021**
(21) Application number: 20158863.9
(22) Date of filing: 21.02.2020
(51) Int. Cl.: H01J 37/28

(54) **INSPECTION APPARATUS**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

A charged-particle assessment tool comprising a plurality of beam columns (230-1, 230-2, ... 230-n). Each beam column comprises: a charged-particle beam source configured to emit charged particles; a plurality of condenser lenses configured to form charged particles emitted from the charged-particle beam source into a plurality of charged-particle beams; and a plurality of objective lenses, each configured to project one of the plurality of charged-particle beams onto a sample. The beam columns are arranged adjacent one-another so as to project the charged particle beams onto adjacent regions of the sample.

## Description

### FIELD

The embodiments provided herein generally relate to a charged particle assessment tools and inspection methods, and particularly to charged particle assessment tools and inspection methods that use multiple sub-beams of charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

There is a general need to improve the throughput and other characteristics of a charged particle inspection apparatus.

### SUMMARY

The embodiments provided herein disclose a charged particle beam inspection apparatus.

According to a first aspect of the invention, there is provided a [**tbc**]

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of exemplary multi-beam apparatus according to an embodiment.
**FIG. 4** is a schematic diagram of another exemplary multi-beam apparatus according to an embodiment.
**FIG. 5** is a graph of landing energy vs. spot size.
**FIG. 6** is an enlarged diagram of an objective lens of an embodiment of the invention.
**FIG. 7** is a schematic cross-sectional view of an objective lens of an inspection apparatus according to an embodiment.
**FIG. 8** is bottom view of the objective lens of **FIG.** 7.
**FIG. 9** is a bottom view of a modification of the objective lens of **FIG.** 7.
**FIG. 10** is an enlarged schematic cross-sectional view of a detector incorporated in the objective lens of **FIG. 7****.**

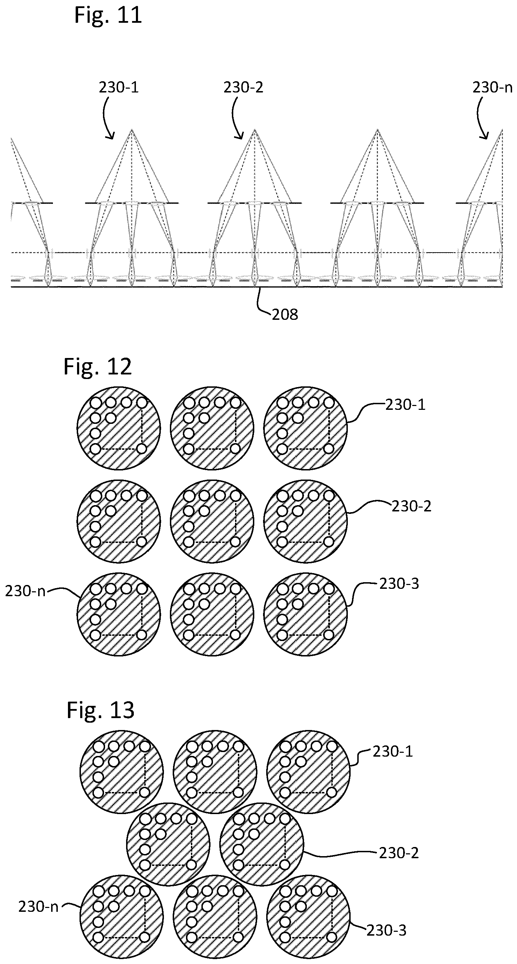

**FIG. 11** is a schematic side view of an inspection tool having multiple adjacent optical columns.
**FIG. 12** is a schematic plan view of an inspection tool having multiple adjacent optical columns in a rectangular arrangement.
**FIG. 13** is a schematic plan view of an inspection tool having multiple adjacent optical columns in a hexagonal arrangement.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises an scanning device and a detector apparatus. The scanning device comprises an illumination apparatus that comprises an electron source and a projection apparatus. The electron source is for generating primary electrons. The projection apparatus is for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

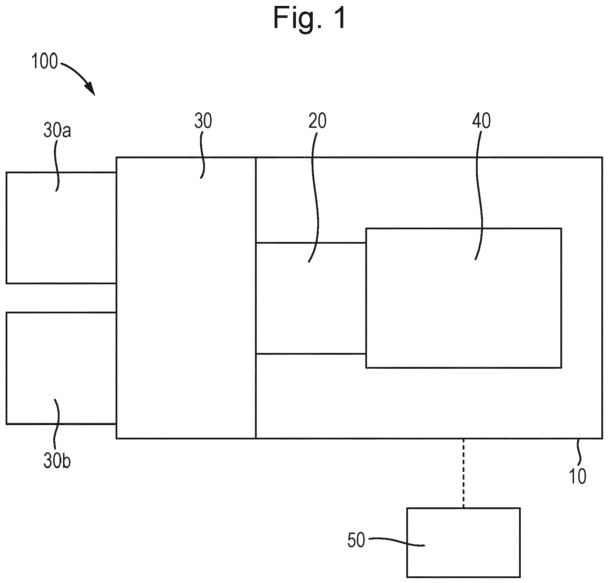

Reference is now made to **FIG. 1**, which is a schematic diagram illustrating an exemplary charged particle beam inspection apparatus 100. The charged particle beam inspection apparatus 100 of Fig. 1 includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs). A FOUP contains a substrate (e.g., a semiconductor substrate or a substrate made of other material(s)) or a sample to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be inspected. An electron beam tool 40 may comprise a multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

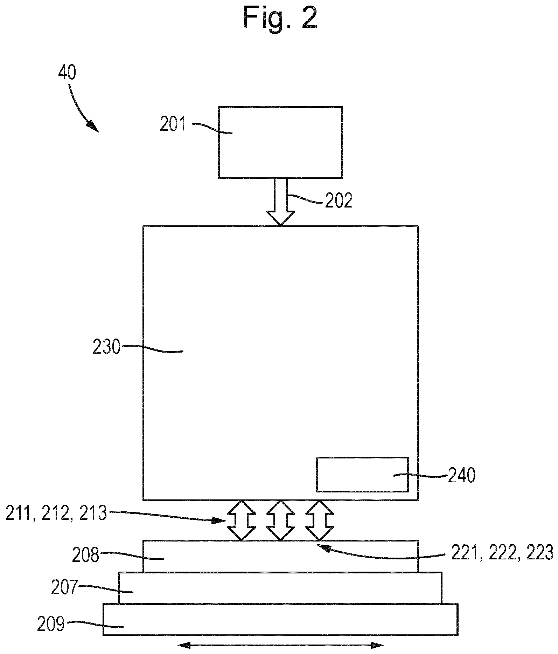

Reference is now made to **FIG. 2**, which is a schematic diagram illustrating an exemplary electron beam tool 40 including a multi-beam inspection tool that is part of the exemplary charged particle beam inspection apparatus 100 of **FIG. 1****.** Multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an electron-optical apparatus. The sample holder 207 is supported by motorized stage 209 so as to hold a sample 208 (e.g., a substrate or a mask) for inspection. Multi-beam electron beam tool 40 further comprises an electron detection device 240.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202.

Projection apparatus 230 is configured to convert primary electron beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

Controller 50 may be connected to various parts of charged particle beam inspection apparatus 100 of **FIG. 1**, such as electron source 201, electron detection device 240, projection apparatus 230, and motorized stage 209. Controller 50 may perform various image and signal processing functions. Controller 50 may also generate various control signals to govern operations of the charged particle beam inspection apparatus, including the charged particle multi-beam apparatus.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons are generated from the sample 208 which include secondary electrons and backscattered electrons. The secondary electrons typically have electron energy ≤ 50 eV. Backscattered electrons typically have electron energy between 50 eV and the landing energy of primary sub-beams 211, 212, and 213.

Electron detection device 240 is configured to detect secondary electrons and/or backscattered electrons and to generate corresponding signals which are sent to controller 50 or a signal processing system (not shown), e.g. to construct images of the corresponding scanned areas of sample 208. Electron detection device may be incorporated into the projection apparatus or may be separate therefrom, with a secondary optical column being provided to direct secondary electrons and/or backscattered electrons to the electron detection device.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

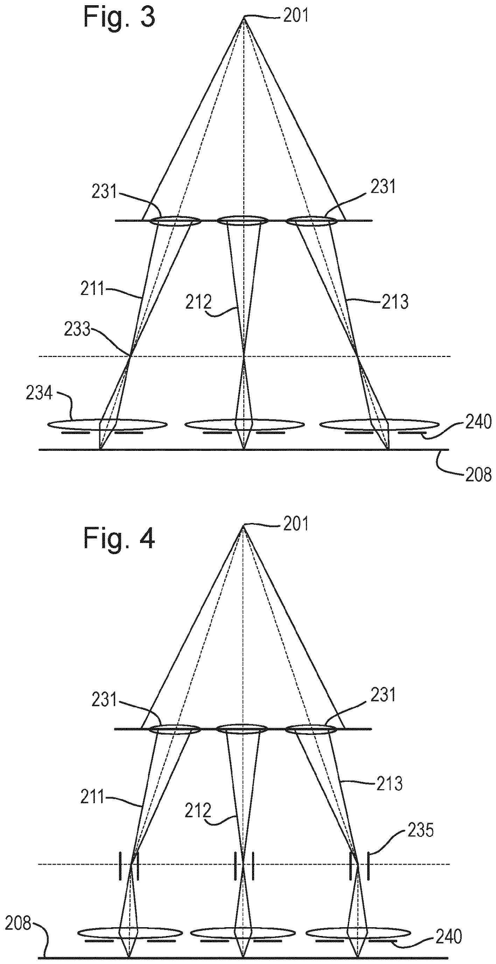

Figure 3 is a schematic diagram of an inspection tool according to an embodiment of the invention. Electron source 201 directs electrodes toward an array of condenser lenses 231 forming part of projection system 230. The electron source is desirably a high brightness thermal field emitter with a good compromise between brightness and total emission current. There may be many tens, many hundreds or many thousands of condenser lenses 231. Condenser lenses are desirably Einzel lenses and may be constructed as described in EP1602121A1, which document is hereby incorporated by reference in particular to the disclosure of a lens array to split an e-beam into a plurality of multi-beams, with the array providing a lens for each beamlet. The lens array may take the form of at least two plates with an aperture in each plate aligned with each other and corresponding to the location of a beamlet. Each plate is maintained during operation at a different potential to achieve the desired lensing effect.

In an arrangement the condenser lens array may be formed of three plate arrays in which the entrance and exit of lens has the same beam energy, which arrangement may be referred to as an Einzel lens. This is beneficial because off-axis chromatic aberrations are limited because dispersion only occurs within the Einzel lens. When the thickness of such a lens is of the order pf a few mm these aberrations are negligible.

Each condenser lens in the array directs electrons into a respective sub-beam 211, 212, 213 which is focused at a respective intermediate focus 233. Downbeam of the intermediate focuses 233 are a plurality of objective lenses 234, each of which directs a respective sub-beam 211, 212, 213 onto the sample 208

By controlling the landing energy of the electrons on the sample it is possible to control focus parameters and introduce other corrections. The landing energy can be selected to increase emission and detection of secondary electrons. A controller provided to control the objective lenses 234 may be configured to control the landing energy to any desired value within a predetermined range or to a desired one of a plurality of predetermined values. In an embodiment, the landing energy can be controlled to desired value in the range of from 1000 eV to 4000 eV.

An electron detection device 240 is provided between the objective lenses 234 and the sample 208 to detect secondary and/or backscattered electrons emitted from the sample 208. An exemplary construction of the electron detection system is described below.

In the system of Figure 3, the beamlets 211, 212, 213 propagate along straight paths from the condenser lenses 231 to the sample 208. A variant construction is shown in Figure 4 which is the same as the system of Figure 3 except that deflectors 235 are provided at the intermediate focuses 233. Deflectors 235 are configured to bend a respective beamlet 211, 212, 213 by an amount effective to ensure that the principal ray (which may also be referred to as the beam axis) is incident on the sample 208 substantially normally (i.e. at substantially 90° to the nominal surface of the sample).

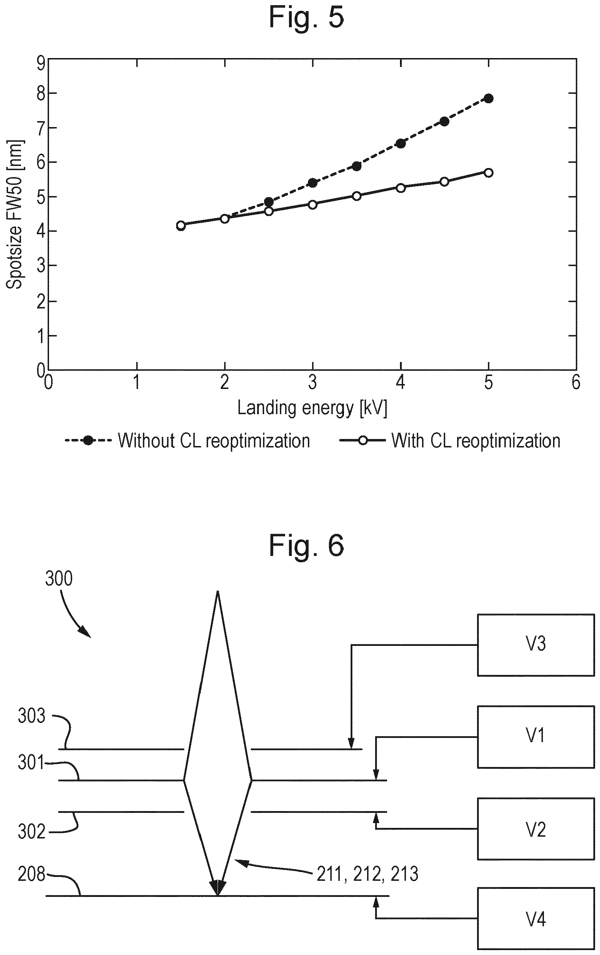

Figure 6 is an enlarged schematic view of one objective lens 300 of the array of objective lenses. Objective lens 300 can be configured to demagnify the electron beam by a factor greater than 10, desirably in the range of 50 to 100 or more. The objective lens comprises a middle or first electrode 301, a lower or second electrode 302 and an upper or third electrode 303. Voltage sources 351, 352, 353 are configured to apply potentials VI, V2, V3 to the first second and third electrodes respectively. A further voltage source is connected to the sample, to apply a fourth potential, which may be ground. Potentials can be defined relative to the sample 208. Desirably, in an embodiment the third electrode is omitted. The first, second and third electrodes are each provided with an aperture through which the respective sub-beam propagates. The second potential can be similar to the potential of the sample, e.g. about 50 V more positive. Alternatively the second potential can be in the range of from about +500 V to about +1,500 V.

The first and/or second potentials can be varied per aperture to effect focus corrections.

To provide the objective lens 300 with a decelerating function, so that the landing energy can be determined, it is desirable to change the potential of the lowest electrode and the sample. To decelerate the electrons the lower (second) electrode is made more negative than the central electrode. The highest electrostatic field strength occurs when the lowest landing energy is selected. The distance between the second electrode and middle electrode, lowest landing energy and maximum potential difference between second electrode and middle electrode are selected so that the resulting field strength is acceptable. For higher landing energies, the electrostatic field becomes lower (less deceleration over the same length).

Because the electron optics configuration between the electron source and beam limiting aperture (just above the condenser lens) remain the same, the beam current remains unchanged with changes in landing energy. Changing the landing energy can affect resolution, either to improve or reduce it. Figure 5 is a graph showing landing energy vs. spot size in two cases. The dashed line with solid circles indicates the effect of changing only the landing energy, i.e. the condenser lens voltage remains the same. The solid line with open circles indicates the effect if the landing energy is changed and condenser lens voltage (magnification versus opening angle optimization) is reoptimized.

If the condenser lens voltage is changed, the collimator will not be in the precise intermediate image plane for all landing energies. Therefore, it is desirable to correct the astigmatism induced by the collimator.

In an embodiment the objective lens referred to in earlier embodiments is an array objective lens. Each element in the array is a micro-lens operating a different beam or group of beams in the multi-beam. An electrostatic array objective lens has at least two plates each with a plurality of holes or apertures. The position of each hole in a plate corresponds to the position of a corresponding hole in the other plate. The corresponding holes operate in use on the same beam or group of beams in the multi-beam. A suitable example of a type of lens for each element in the array is an two electrode decelerating lens. Additional electrodes can be provided. The bottom electrode of objective lens is a CMOS chip detector integrated into a multi-beam manipulator array. Integration of a detector array into the objective lens replaces a secondary column. The CMOS chip is preferably orientated to face a sample (because of the small distance (e.g. 100µm) between wafer and bottom of the electron-optical system). In an embodiment, electrodes to capture the secondary electron signals are formed in the top metal layer of the CMOS device. The electrodes can be formed in other layers. Power and control signals of the CMOS may be connected to the CMOS by through-silicon vias. For robustness, preferably the bottom electrode consist of two elements: the CMOS chip and a passive Si plate with holes. The plate shields the CMOS from high E-fields.

In order to maximize the detection efficiency it is desirable to make the electrode surface as large as possible, so that substantially all the area of the array objective lens (excepting the apertures) is occupied by electrodes and each electrode has a diameter substantially equal to the array pitch. In an embodiment the outer shape of the electrode is a circle, but this can be made a square to maximize the detection area. Also the diameter of the through-substrate hole can be minimized. Typical size of the electron beam is in the order of 5 to 15 micron.

In an embodiment, a single electrode surrounds each aperture. In another embodiment, a plurality of electrode elements are provided around each aperture. The electrons captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller. Especially in case a larger electrode gives only a slightly larger detection efficiency, but a significantly larger crosstalk.

The back-scattered and/or secondary electron current collected by electrode is amplified by a Trans Impedance Amplifier.

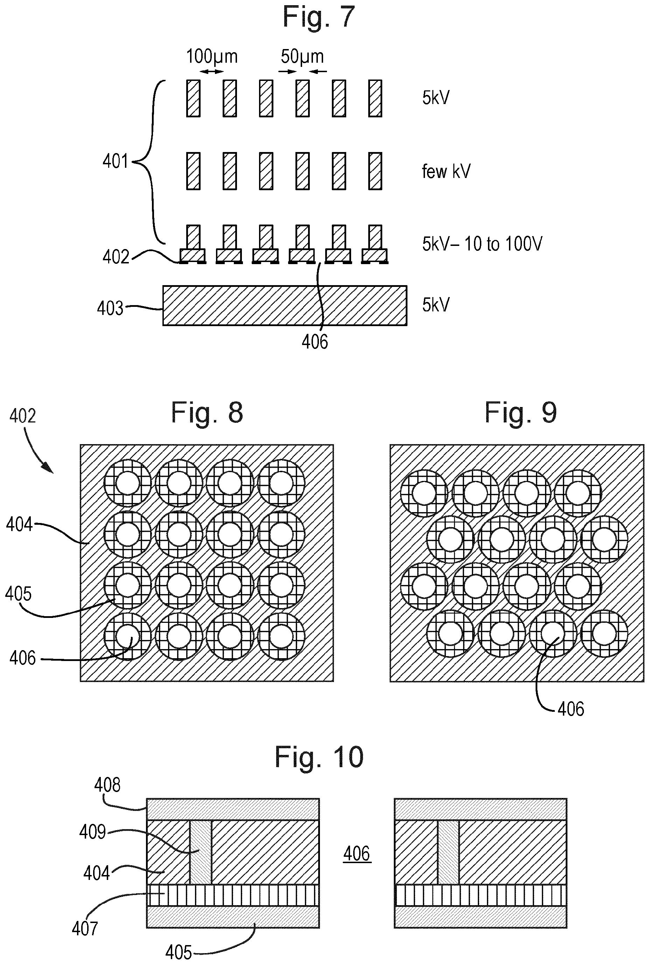

An exemplary embodiment is shown in Fig. 7 which illustrates a multibeam objective lens 401 in schematic cross section. On the output side of the objective lens 401, the side facing the sample 403, a detector module 402 is provided. Figure 8 is a bottom view of detector module 402 which comprises a substrate 404 on which are provided a plurality of capture electrodes 405 each surrounding a beam aperture 406. The beam apertures 406 may be formed by etching through substrate 404. In the arrangement shown in Figure 8, the beam apertures 406 are shown in a rectangular array. The beam apertures 406 can also be differently arranged, e.g. in a hexagonal close packed array as depicted in Figure 9.

Figure 10 depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallisation layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

The integrated detector array described above is particularly advantageous when used with a tool having tunable landing energy as secondary electron capture can be optimized for a range of landing energies.

It is desirable to increase the rate (area per unit time) at which a sample can be assessed or inspected. In a tool using charged-particle beams, it is not generally possible to increase speed of operation by increasing the beam intensity because of limitations on source brightness and total emission current. Increase beam current can also increase stochastic effects due to the mutual repulsion of the charged particles.

It is proposed to provide a tool that comprises a plurality of beam columns, each as described above, adjacent each other so as to project charged-particle beams onto the same sample. An increased area of the sample can thereby be assessed at one go. To minimize the spacing between columns, it is desirable that the condenser lenses and/or objective lenses are formed as MEMS or CMOS devices. If collimators are present it is desirable that the collimators are also formed as MEMS or CMOS devices. The collimators may be deflectors and may referred to as collimator deflectors.

As mentioned above, each sub-beam of a beam column can be scanned across a respective individual scanning area of the object plane in which the sample is placed, which can be referred to as the sub-beam addressable area. The sub-beam addressable areas of all sub-beams of a beam column can be collectively referred to as the column-addressable area. The column-addressable area is not contiguous because the scanning range of the sub-beams is less than the pitch of the objective lenses. A contiguous region of the sample can be scanned by mechanically scanning the sample through the object plane. The mechanical scan of the sample can be a meander or step-and-scan type movement.

A contiguous area encompassing the column-addressable area is referred to herein as a region. A region can be a circle or polygon. The region is the smallest such shape that encompasses the column-addressable area. Regions addressed by adjacent columns are adjacent on the sample when placed in the object plane. Adjacent regions do not necessarily abut. The columns may be arranged to cover at least a portion to all of the sample. The regions may be spaced apart so that a full portion can be projected onto by the column. The stage may move relative to the column so that the regions associated with the columns cover the full portion of the sample preferably without overlap. The footprint of a column (i.e. the projection of the column onto the object plane) is likely larger than the region into which the column projects sub-beams.

In an embodiment focus correctors to correct the focus of individual beams or groups of beams on the sample, so as to account for any unflatness in the sample, are provided. Focus correctors may be electrostatic and/or mechanical. A focus correction can include any or all of corrections in the Z, Rx and Ry directions. A mechanical focus corrector can include actuators configured to tilt and/or shift an entire column or just part of it, e.g. the objective lens array.

In an embodiment the objective lenses have astigmatism correctors. The astigmatism correctors can be combined with focus correctors

In some embodiments, the charged particle assessment tool further comprises one or more aberration correctors that reduce one or more aberrations in the sub-beams. In an embodiment, each of at least a subset of the aberration correctors is positioned in, or directly adjacent to, a respective one of the intermediate foci (e.g. in or adjacent to the intermediate image plane 233, 235). The sub-beams have a smallest sectional area in or near a focal plane such as the intermediate plane. This provides more space for aberration correctors than is available elsewhere, i.e. upbeam or downbeam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different beams. Correctors can be used to correct macroscopic aberrations resulting from the source that prevent a good alignment between each sub-beam and a corresponding objective lens.

The aberration correctors may correct aberrations that prevent a proper column alignment. Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses 231 are vertically close or coincident with the beam apertures. A challenge with positioning correctors at or near the condenser lenses 231, however, is that the sub-beams each have relatively large sectional areas and relatively small pitch at this location, relative to locations further downstream.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212,214 over the sample 208. In an embodiment, the scanning deflectors may be used as described in EP2425444A1 (hereby incorporated by reference in its entirety, and in particular to the disclosure of the use of an aperture array as a scanning deflector).

The aberration correctors may be CMOS based individual programmable deflectors as disclosed in EP2702595A1 or an array of multipole deflectors as disclosed in EP2715768A2, of which the descriptions of the beamlet manipulators in both documents are hereby incorporated by reference.

In an embodiment, such as shown in Fig 3. aberration correctors, for example the aberration correctors 126 associated with the objective lenses 234, comprise field curvature correctors that reduce field curvature. Reducing field curvature reduces errors caused by field curvature, such as astigmatism and focus error. In the absence of correction, significant field curvature aberration effects are expected to occur at the objective lenses 234 in embodiments where the sub-beams 211, 212, 213 propagate along straight-line paths between the condenser lenses 231 and the objective lenses 234 due to the resulting oblique angles of incidence onto the objective lenses 234. Field curvature effects could be reduced or removed by collimating the sub-beams 211, 212, 213 before the sub-beams 211, 212, 213 reach the objective lenses 234. However, the provision of collimators upstream of the objective lenses 234 would add complexity, as related in the embodiment shown in Fig 4. The field curvature correctors make it possible to avoid collimators and thereby reduce complexity. As mentioned above, the absence of collimators upstream of the objective lenses 234 may additionally allow the beam current to be increased by allowing the objective lenses to be provided at a larger pitch.

In an embodiment, the field curvature correctors are integrated with, or directly adjacent to, one or more of the objective lenses 234. In an embodiment, the field curvature correctors comprise passive correctors. Passive correctors could be implemented, for example, by varying the diameter and/or ellipticity of apertures of the objective lenses 118. The passive correctors may be implemented for example as described in EP2575143A1 hereby incorporated by reference in particular to the disclosed use of aperture patterns to correct astigmatism. The passive nature of passive correctors is desirable because it means that no controlling voltages are required. In embodiments where the passive correctors are implemented by varying the diameter and/or ellipticity of apertures of the objective lenses 118, the passive correctors provide the further desirable feature of not requiring any additional elements, such as additional lens elements. A challenge with passive correctors is that they are fixed, so the required correction needs to be carefully calculated in advance. Additionally or alternatively, in an embodiment, the field curvature correctors comprise active correctors. The active correctors may controllably correct charged particles to provide the correction. The correction applied by each active corrector may be controlled by controlling the potential of each of one or more electrodes of the active corrector. In an embodiment, passive correctors apply a coarse correction and active correctors apply a finer and/or tunable correction.

In an embodiment the beam columns are arranged in a rectangular array.

In an embodiment the beam columns are arranged in a hexagonal array.

In an embodiment the number of beam columns is in the range of from 9 to 200.

In an embodiment the number of condenser lens in each beam column is in the range of from 1,000 to 100,000, desirably from 5,000 to 25,000.

In an embodiment the condenser lenses of each beam column are arranged in a respective array having a pitch in the range of from 50 to 500 µm, desirably in the range of from 70 to 150 µm.

In an embodiment n the condenser lenses and/or the objective lenses are formed as MEMS or CMOS devices.

In an embodiment one or more aberration correctors configured to reduce one or more aberrations in the sub-beams are provided.

In an embodiment each of at least a subset of the aberration correctors is positioned in, or directly adjacent to, a respective one of the intermediate foci.

A tool according to any of the preceding claims further comprising one or more scanning deflectors for scanning the sub-beams over the sample are provided.

In an embodiment the one or more scanning deflectors are integrated with, or are directly adjacent to, one or more of the objective lenses.

In an embodiment the collimator is one or more collimator deflectors.

In an embodiment the one or more collimator deflectors are configured to bend a respective beamlet by an amount effective to ensure that the principal ray of the sub-beam is incident on the sample substantially normally.

In an embodiment detectors integrated into the objective lenses are provided.

An assessment tool according to an embodiment of the invention may be a tool which makes a qualitative assessment of a sample (e.g. pass/fail), one which makes a quantitative measurement (e.g. the size of a feature) of a sample or which generates an image of map of a sample. Examples of assessment tools are inspection tools and metrology tools.

The term 'adjacent' may include the meaning 'abut'.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A charged-particle assessment tool comprising:
a plurality of beam columns, each beam column comprising: a charged-particle beam source configured to emit charged particles; a plurality of condenser lenses configured to form charged particles emitted from the charged-particle beam source into a plurality of charged-particle beams; and a plurality of objective lenses, each configured to project one of the plurality of charged-particle beams onto a sample; wherein:
the beam columns are arranged adjacent one-another so as to project the charged particle beams onto adjacent regions of the sample.

2. A tool according to claim 1 further comprising focus correctors.

3. A tool according to claim 1 or 2 wherein the objective lenses have astigmatism correctors.

4. A tool according to claim 1, 2 or 3 wherein the beam columns are arranged in a rectangular array.

5. A tool according to claim 1, 2 or 3 wherein the beam columns are arranged in a hexagonal array.

6. A tool according to any one of the preceding claims wherein the number of beam columns is in the range of from 9 to 200.

7. A tool according to any one of the preceding claims wherein the number of condenser lens in each beam column is in the range of from 1,000 to 100,000, desirably from 5,000 to 25,000.

8. A tool according to any one of the preceding claims wherein the condenser lenses of each beam column are arranged in a respective array having a pitch in the range of from 50 to 500 µm, desirably in the range of from 70 to 150 µm.

9. A tool according to any one of the preceding claims wherein the condenser lenses and/or the objective lenses are formed as MEMS or CMOS devices.

10. A tool according to any one of the preceding claims further comprising one or more aberration correctors configured to reduce one or more aberrations in the sub-beams.

11. A tool according to claim 9, wherein each of at least a subset of the aberration correctors is positioned in, or directly adjacent to, a respective one of the intermediate foci.

12. A tool according to any of the preceding claims further comprising one or more scanning deflectors for scanning the sub-beams over the sample and optionally the one or more scanning deflectors are integrated with, or are directly adjacent to, one or more of the objective lenses.

13. A tool according to any of the preceding claim, wherein the collimator is one or more collimator deflectors and optionally the one or more collimator deflectors are configured to bend a respective beamlet by an amount effective to ensure that the principal ray of the sub-beam is incident on the sample substantially normally.

14. A tool according to any one of the preceding claims further comprising detectors integrated into the objective lenses.

15. An inspection method comprising:
using a plurality of beam columns to emit charged-particle beams toward a sample, each beam column comprising: a charged-particle beam source configured to emit charged particles; a plurality of condenser lenses configured to form charged particles emitted from the charged-particle beam source into a plurality of charged-particle beams; and a plurality of objective lenses, each configured to project one of the plurality of charged-particle beams onto the sample; wherein:
the beam columns are arranged adjacent one-another so as to project the charged particle beams onto adjacent regions of the sample.
